# EUROPÄISCHE PATENTANMELDUNG

(11) **EP 1 170 110 A1**
(43) Veröffentlichungstag der Anmeldung: **09.01.2002**
(21) Anmeldenummer: 01890187.6
(22) Anmeldetag: 13.06.2001
(51) Int. Cl.: B29C 45/14, B29C 45/16, H05K 3/20

(54) **Verfahren zum Herstellen einer kunststoffumspritzten Leiterstruktur einer elektrischen Schaltungseinheit sowie eine elektrische Schaltungseinheit mit einer kunststoffumspritzten Leiterstruktur**

(30) Priorität: 07.07.2000 AT 11652000
(71) Anmelder: ERNST POLLMANN UHREN- U.APPARATEBAU OHG, A-3822 Karlstein/Thaya (AT)
(72) Erfinder: Pollmann, Robert, 3822 Karlstein/Thaya (AT); Fux, Reinhard, 3822 Karlstein/Thaya (AT)
(74) Vertreter: Weinzinger, Arnulf, Dipl.-Ing.

(57) **Zusammenfassung**

Die Erfindung betrifft ein Verfahren zum Herstellen einer kunststoffumspritzten Leiterstruktur (1)einer elektrischen Schaltungseinheit, wobei die Leiterstruktur (1) in eine Spritzgussform eingelegt und in einem ersten Kunststoffspritzvorgang teilweise umspritzt wird, sowie eine elektrische Schaltungseinheit mit einer kunststoffumspritzten Leiterstruktur (1). Zur Schaffung eines besonders rasch und billig durchführbaren Verfahrens und einer besonders dichten elektrischen Schaltungseinheit ist vorgesehen, dass mindestens ein elektronischer Bauteil (10) od.dgl. an der, Leiterstruktur (1) fixiert wird, und dass in einem weiteren Kunststoffspritzvorgang die teilweise umspritzte Leiterstruktur (1) samt dem zumindest einen Bauteil (10) od.dgl. umspritzt wird. Beim ersten Kunststoffspritzvorgang wird vorzugsweise zumindest ein Bauteil-Tragelement (9) aus dem Kunststoff, beispielsweise mit einem Schnappverbindungsteil oder in Form eines Presssitzelementes mitgespritzt, auf dem nach dem Erstarren der Bauteil (10) od.dgl. positioniert wird. Derartig hergestellte elektrische Schaltungseinheiten benötigen weniger Schnittstellen nach außen, da zumindest ein Teil der elektronischen Bauteile bereits integriert ist. Dadurch wird der Grad an Dichtheit und somit die Widerstandsfähigkeit gegen äußere Einflüsse weiter erhöht.

## Beschreibung

Die Erfindung betrifft ein Verfahren zum Herstellen einer kunststoffumspritzten Leiterstruktur einer elektrischen Schaltungseinheit, wobei die Leiterstruktur in eine Spritzgussform eingelegt und in einem ersten Kunststoffspritzvorgang teilweise umspritzt wird, sowie eine elektrische Schaltungseinheit mit einer kunststoffumspritzten Leiterstruktur.

Häufig werden Leiterstrukturen mit Kunststoff umspritzt, um dadurch eine Abdichtung gegenüber äußeren Einflüssen zu erzielen oder die Leiterstruktur elektrisch zu isolieren.

Insbesondere bei Teilen für die Autoindustrie, wie beispielsweise Türschlössern oder Scheibenwischerantrieben, kann es durch Wassereintritt zu Fehlfunktionen kommen. Zur Vermeidung solcher Fehlfunktionen werden die elektronischen Bauteile bzw. andere empfindliche Komponenten häufig mit Vergussmasse umhüllt oder bedeckt, wodurch jedoch nur eine unzureichende Dichtheit erzielt werden kann.

Zur Ummantelung von Leiterstrukturen ist es bekannt, die meist als Stanzgitter vorliegenden Leiterbahnen in eine Spritzgussform einzulegen und teilweise mit Kunststoff zu umspritzen. Allfällige metallische Stege, welche die Leiterbahnen in dem Stanzgitter miteinander verbinden, werden aufgetrennt. Ein Verfahren dieser Art ist beispielsweise aus der DE 44 07 508 A1 bekannt, bei welchem zur Schaffung eines besonders preiswerten Verfahrens zur Einbettung elektrischer Leiterbahnen in Kunststoff vorgesehen ist, das Stanzgitter in die Spritzgussform einzulegen, die Leiterbahnen durch Aufstecken eines elektrisch isolierenden Formteiles zu fixieren, die Stege des Stanzgitters zu trennen und danach den Kunststoff in die Spritzgussform einzuspritzen. Das Verfahren verwendet verlorene Formteile aus elektrisch isolierendem Werkstoff, insbesondere Formteile aus dem gleichen Kunststoff, mit welchem die Leiterbahnen umspritzt werden. Derartige vorgefertigte Formteile erfordern einen höheren Aufwand beim Einlegen in die Spritzgussform bzw. beim Anordnen der Formteile an den Leiterbahnen und sind darüber hinaus nicht exakt positionierbar.

Man ist bestrebt, nach dem vorliegenden Verfahren hergestellte Produkte mit möglichst wenig Steckkontakten bzw. Anschlüssen zu versehen, um dadurch die Dichtheitsprobleme zu reduzieren. Dies wird dadurch erreicht, dass ein Teil der Elektronik integriert wird, indem auf dem Leiterbahngebilde elektronische Bauelemente angeordnet werden.

Bisher wurden elektronische Bauteile mit Vergussmasse abgedichtet. Es ist nicht bekannt, beim Verfahren zum Herstellen kunststoffumspritzter Leiterstrukturen elektronische Bauteile anzuordnen und diese mit Kunststoff zu umspritzen. Ein Hindernis dafür scheint die Tatsache zu sein, dass die Positionierung der Bauteile unter dem Spritzdruck ein Problem darstellt. Darüber hinaus wurde ein Einbau elektronischer Bauteile auf Grund der relativ hohen auftretenden Temperaturen während des Spritzgussvorganges vermieden.

Bekannt sind lediglich Verfahren zum Umhüllen elektronischer Komponenten mit dem Zwecke der Herstellung der Gehäuse der Komponenten selbst. Beispielsweise beschreibt die DE 1 902 832 A1 ein derartiges Verfahren, bei dem die Komponenten in eine Gießform eingelegt werden und während des Ausfüllens der Form mit Gießmasse mit Stempeln gehalten werden, wobei nach Entfernung der Stempel eine vollständige Ausfüllung der Gießform erfolgt. Bei der Klemmung der mit dem Gehäuse zu umhüllenden Komponenten in der Gießform kann es auf Grund von Toleranzen der Komponenten zu unzulässigen Belastungen der eigentlichen elektronischen Komponenten kommen und in der Folge zu Fehlfunktionen.

Aufgabe der vorliegenden Erfindung ist die Schaffung eines Verfahrens zum Herstellen kunststoffumspritzter Leiterstrukturen, mit dem ein höherer Grad der Integration der damit hergestellten Produkte erzielt werden kann und welches Verfahren darüber hinaus rasch und kostengünstig durchgeführt werden kann. In entsprechender Weise sollen die erfindungsgemäßen elektrischen Schaltungseinheiten einen möglichst hohen Grad an Dichtheit aufweisen, so dass darin enthaltene elektronische Bauelemente vor äußeren Einflüssen geschützt sind und somit die Wahrscheinlichkeit von Fehlfunktionen deutlich reduziert werden kann.

In verfahrensmäßiger Hinsicht wird die erfindungsgemäße Aufgabe dadurch gelöst, dass mindestens ein elektronischer Bauteil od.dgl. an der Leiterstruktur fixiert wird, und dass in einem weiteren Kunststoffspritzvorgang die teilweise umspritzte Leiterstruktur samt dem zumindest einen elektronischen Bauteil od.dgl. umspritzt wird. Durch die Fixierung der elektronischen Bauteile werden diese in ihrer Lage gehalten, sodass sie sich während des weiteren Kunststoffspritzvorganges nicht verschieben können. Die Fixierung der elektronischen Bauteile erfolgt dabei vorzugsweise durch Anlöten. Das erfindungsgemäße Verfahren zeichnet sich durch besondere Schnelligkeit und Einfachheit, insbesondere bei der Massenfertigung, aus. Derartig hergestellte Produkte weisen eine besonders hohe Dichtheit auf, weshalb ein Einsatz, insbesondere in der Autoindustrie bevorzugt möglich ist.

Vorteilhafterweise wird zumindest ein Bauteil od.dgl. nach dem ersten Kunststoffspritzvorgang an der Leiterstruktur fixiert, insbesondere angelötet. Alternativ dazu kann die Fixierung der Bauteile aber auch vor dem ersten Spritzvorgang erfolgen.

Gemäß einem weiteren Merkmal der Erfindung ist vorgesehen, dass beim ersten Kunststoffspritzvorgang zumindest ein Bauteil-Tragelement aus dem Kunststoff mitgespritzt wird, auf dem nach dem Erstarren zumindest ein elektronischer Bauteil od.dgl. positioniert wird. Durch die Herstellung des Tragelements während des ersten Kunststoffspritzvorganges können die elektronischen Bauteile oder andere Komponenten rasch und einfach an den entsprechenden Stellen der Leiterstrukturen angeordnet werden und danach allenfalls mit den Leiterbahnen, beispielsweise durch Löten, verbunden werden. Dadurch wird die Position der elektronischen Bauteile oder anderer Komponenten beim weiteren Kunststoffspritzvorgang gesichert, und diese Bauteile bzw. Komponenten können somit dicht und sicher ummantelt werden. Die Wahrscheinlichkeit eines Lösens der elektrischen Verbindungen zwischen Bauteil und Leiterbahn wird dadurch noch weiter reduziert.

Gemäß einem weiteren Merkmal der Erfindung ist vorgesehen, dass ein thermoplastischer Kunststoff zum Umspritzen der Leiterstruktur verwendet wird. Es ist die Verwendung sämtlicher technischer Thermoplaste denkbar. Der erforderliche Druck und die erforderliche Temperatur während des Spritzgussvorganges sollen für eine möglichst geringe Belastung der elektronischen Bauteile oder anderer Komponenten möglichst gering sein.

Die während des ersten Kunststoffspritzvorganges mitgeformten Tragelemente können beispielsweise mit zumindest einem Schnappverbindungsteil oder als Presssitzelement geformt werden, in welche die elektronischen Bauteile od.dgl. mit möglichst geringem Aufwand eingelegt bzw. eingeschnappt werden können und in welchen die elektronischen Bauteile od.dgl. möglichst sicher gehalten werden, so dass ein Verrutschen während des zweiten Kunststoffspritzvorganges nicht möglich ist. Andererseits soll die Schnappverbindung bzw. das Presssitzelement keine unzulässigen Belastungen auf das Bauteil ausüben. Neben den genannten Konstruktionen sind auch einfache schalenförmige Ausbildungen der Tragelemente, in welche die elektronischen Bauteile od.dgl. eingelegt werden, möglich.

Allenfalls vorhandene mechanische Stütz- oder Verbindungsstege zwischen den Leiterbahnen der als Leiterbahn-Stanzteil ausgebildeten Leiterstruktur werden nach dem ersten Kunststoffspritzvorgang oder nach dem Fixieren allfälliger elektronischer Bauteile od.dgl. nach an sich bekannten Methoden aufgetrennt bzw. entfernt.

Das erfindungsgemäße Verfahren kann noch rascher und kostengünstiger durchgeführt werden, wenn die elektronischen Bauteile über lokale elektrische Erwärmung benachbarter Leiterbahnteile der Leiterstruktur angelötet werden. Zu diesem Zweck müssen lediglich die Leiterbahnen in der Umgebung der gewünschten Lötstellen kontaktiert werden und ein entsprechender elektrischer Strom bzw. eine entsprechende elektrische Spannung angelegt werden. Der resultierende Strom ruft auf Grund des ohmschen Widerstands der Leiterbahn eine Verlustwärme hervor, welche das aufgebrachte Lötzinn zum Schmelzen bringt und eine sichere Lötverbindung zwischen Leiterbahn und Bauteilanschluss bewirkt. Ein derartiges Verfahren weist eine geringere thermische Belastung des Bauteiles auf als herkömmliche Lötverfahren und kann einfach automatisiert werden.

Wenn der Druck und bzw. oder die Temperatur der Kunststoffmasse in der Umgebung der zu umspritzenden Leiterstruktur während der Spritzvorgänge mit geeigneten Sensoren erfasst wird, kann eine Qualitätskontrolle durchgeführt werden. Im Falle des Erreichens unzulässig hoher Werte für den Druck oder die Temperatur während der Spritzvorgänge können die hergestellten Produkte ausgesondert, einer zusätzlichen Prüfung oder einer Vernichtung zugeführt werden.

Gelöst wird die erfindungsgemäße Aufgabe auch durch eine elektrische Schaltungseinheit mit einer kunststoffumspritzten Leiterstruktur, wobei aus dem für die Umspritzung verwendeten Kunststoff zumindest ein Tragelement gebildet ist, welches zumindest ein elektronisches Bauteil od.dgl. trägt, das mit einem weiteren Mantel aus umspritztem Kunststoff umhüllt ist. Eine elektrische Schaltungseinheit mit diesen Merkmalen ist besonders dicht gegenüber äußeren Einflüssen, wodurch eine Anwendung insbesondere in der Autoindustrie möglich wird. Beispielsweise können derartige elektrische Schaltungseinheiten in Türschlössern für Kraftfahrzeuge, welche immer den äußeren Witterungseinflüssen ausgesetzt sind, eingesetzt werden. Darüber hinaus sind solche Schaltungseinheiten sehr rasch und billig, insbesondere bei der Massenproduktion, herstellbar.

Vorteilhafterweise wird die Umspritzung aus einem thermoplastischen Kunststoff hergestellt, wobei sämtliche technische Thermoplaste zur Anwendung kommen.

Gemäß einem weiteren Merkmal der Erfindung weist das Tragelement einen Schnappverbindungsteil auf. In diesen kann ein entsprechender elektronischer Bauteil od.dgl. rasch und einfach eingesetzt werden, wobei ein ausreichender Halt während der Umspritzung mit Kunststoff gewährleistet wird. Als Schnappverbindungsteile kommen beispielsweise widerhakenförmige Konstruktionen od.dgl. in Frage. Alternativ dazu können Tragelemente auch als Presssitzelemente ausgebildet sein, in welche die elektronischen Bauteile od.dgl. eingeschoben oder eingedrückt werden. Darüber hinaus sind auch Tragelemente in Form von Schalen oder Ähnlichem, in welche die elektronischen Bauteile oder andere Komponenten eingelegt werden, möglich.

Vorteilhafterweise ist das zumindest eine elektronische Bauteil od.dgl. als temperaturbeständiges Bauteil od.dgl. ausgebildet, so dass während des weiteren Spritzgussvorganges keine thermische Überbelastung des Bauteils eintritt.

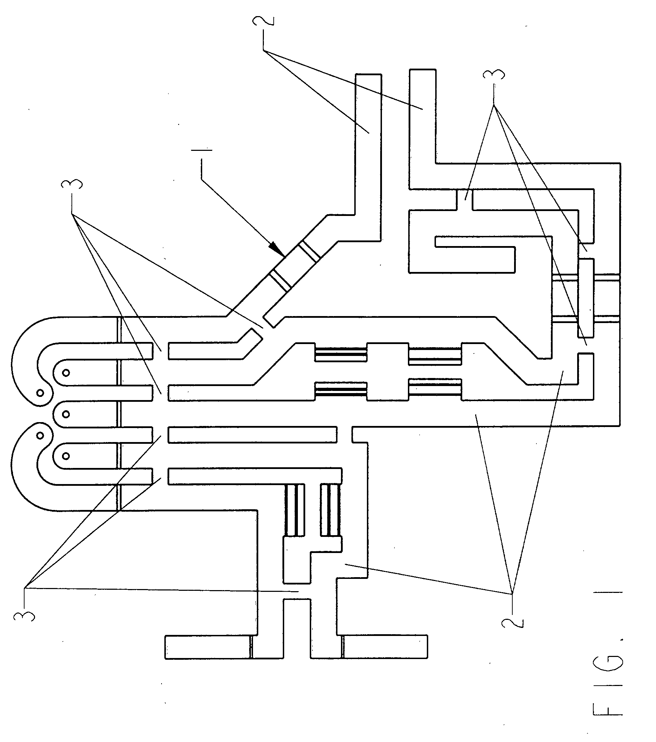

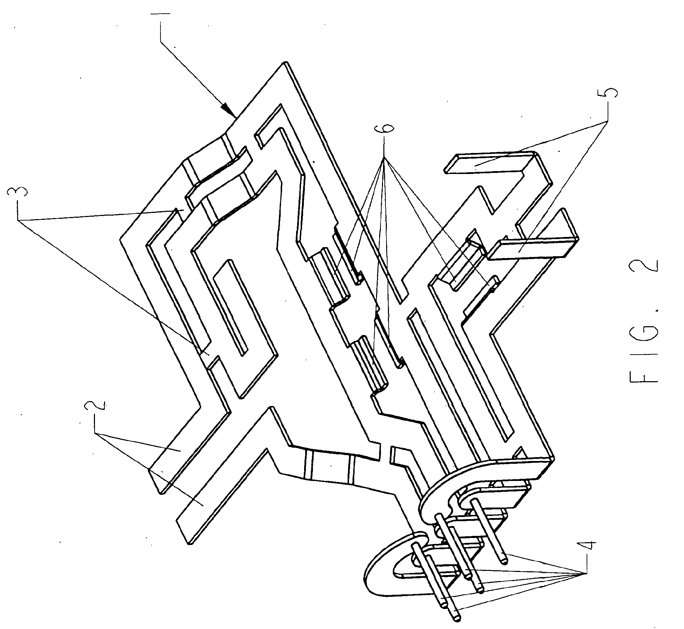

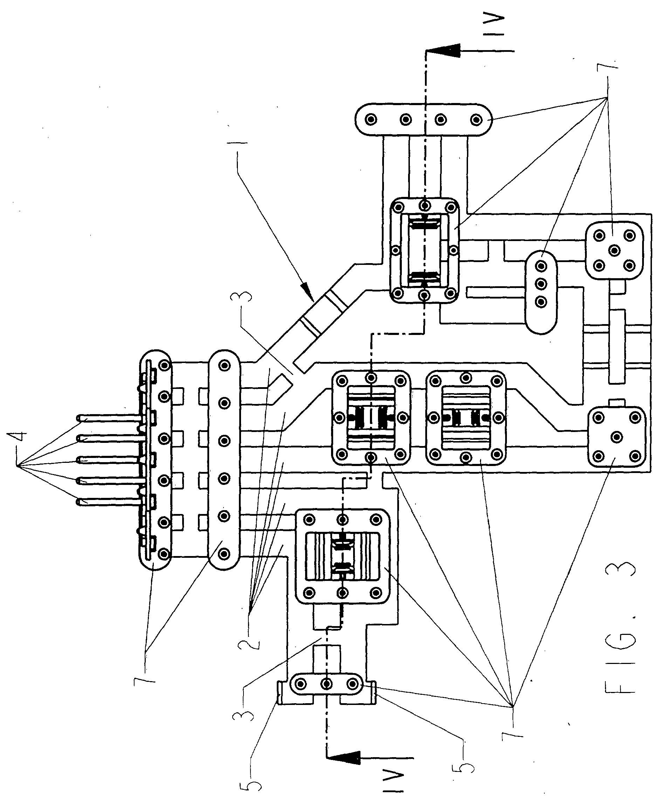

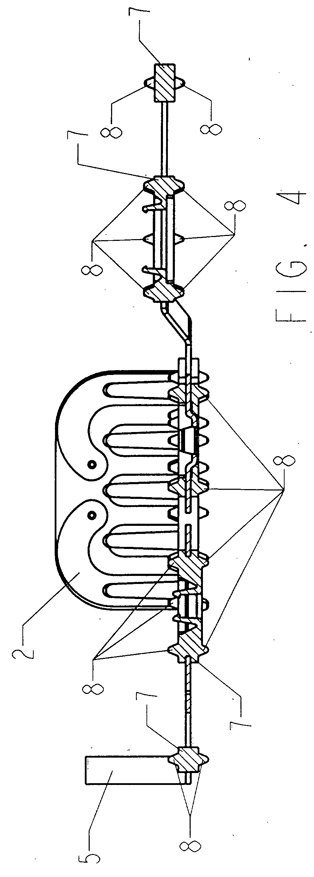

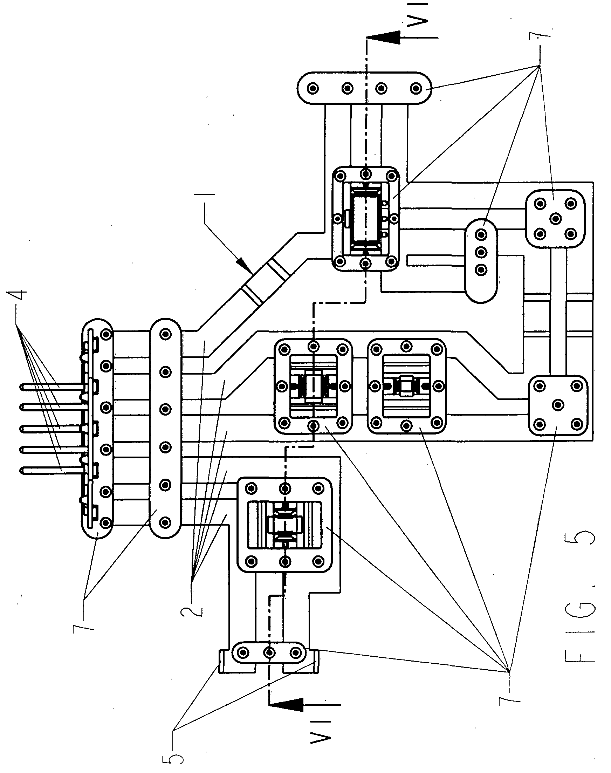

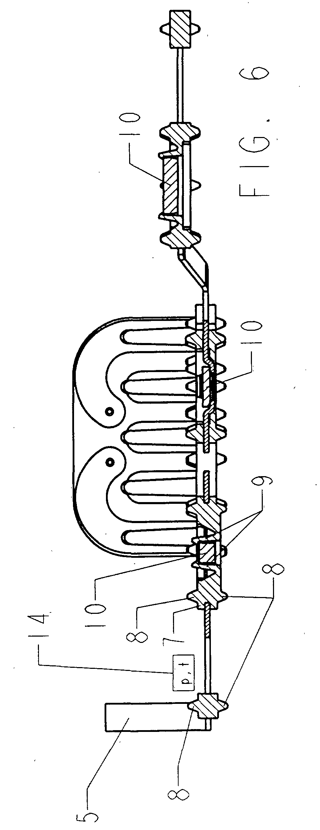

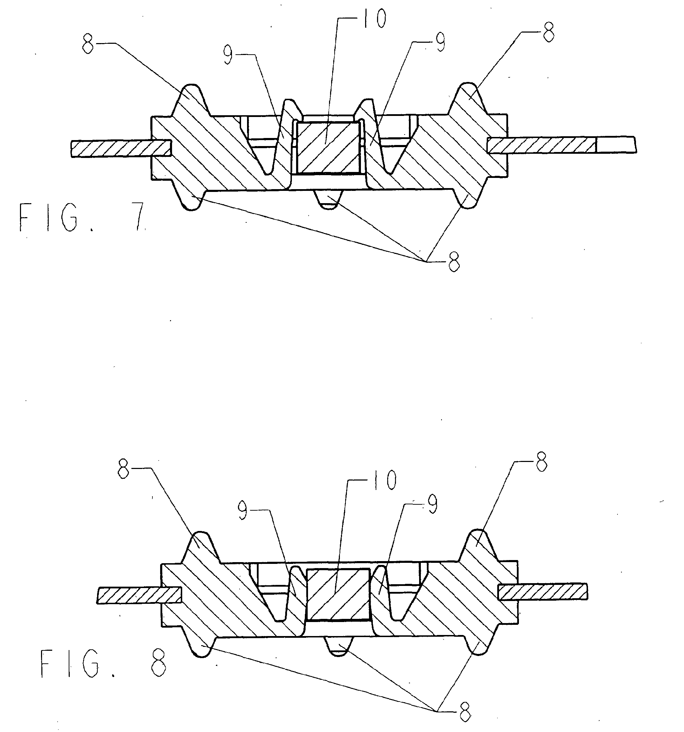

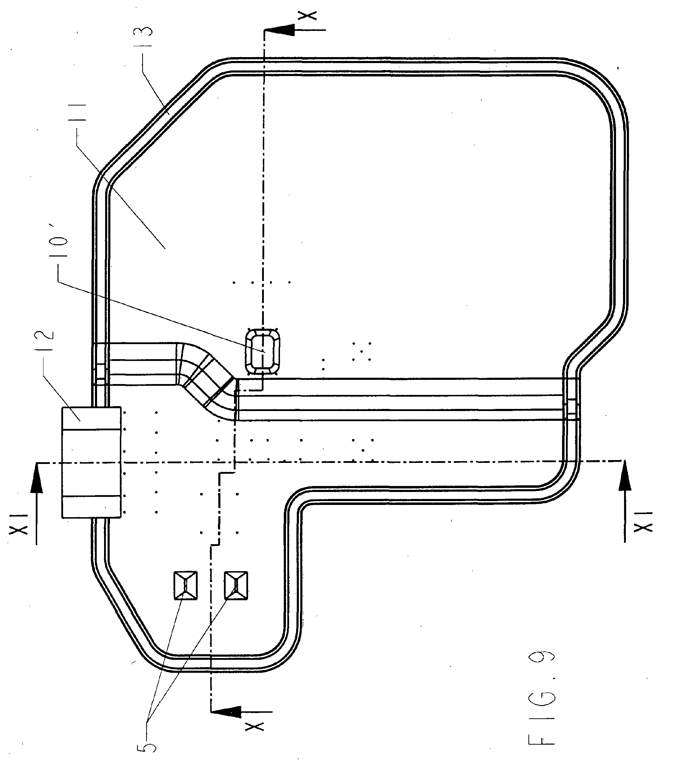

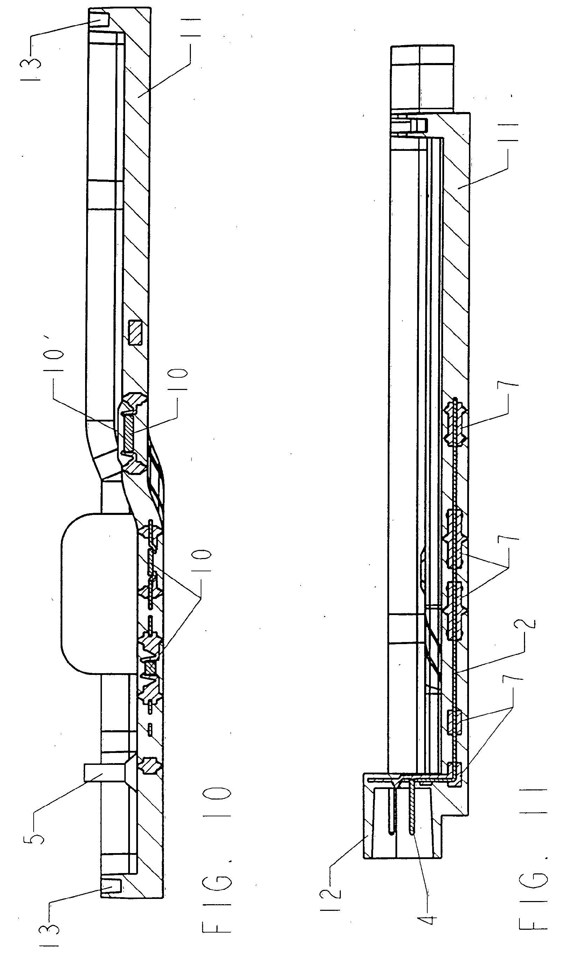

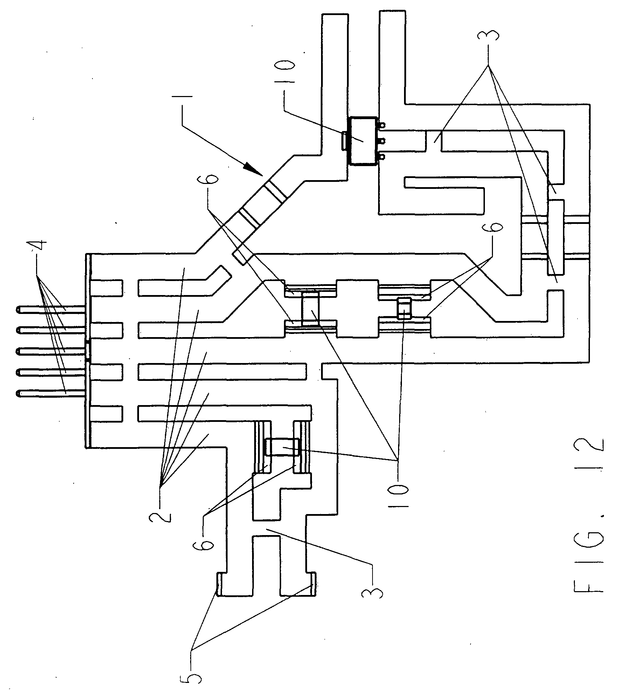

Die Erfindung wird an Hand der Zeichnungen, welche ein Ausführungsbeispiel der Erfindung zeigen, noch weiter erläutert. Darin zeigen Fig. 1 eine Leiterstruktur in Draufsicht, Fig. 2 die Leiterstruktur nach einem Biegevorgang in perspektivischer Ansicht, Fig. 3 die Draufsicht auf die Leiterstruktur nach einem ersten Kunststoffspritzvorgang, Fig. 4 ein Schnittbild durch die Leiterstruktur gemäß Fig. 3 entlang der Schnittlinie IV-IV, Fig. 5 eine Draufsicht auf die Leiterstruktur gemäß Fig. 3 nach dem Auftrennen der Stützstege zwischen den Leiterbahnen, Fig. 6 einen Schnitt durch die Leiterstruktur gemäß Fig. 5 entlang der Schnittlinie VI-VI nach dem Einlegen elektrischer Bauteile, Fig. 7 und Fig. 8 zwei Ausführungsvarianten der Bauteil-Tragelemente im Querschnitt in vegrößerter Darstellung, Fig. 9 die Draufsicht auf die Leiterstruktur nach einem weiteren Kunststoffspritzvorgang, Fig. 10 einen Schnitt durch die Leiterstruktur gemäß Fig. 9 entlang der Schnittlinie X-X, Fig. 11 einen Schnitt durch die Leiterstruktur gemäß Fig. 9 entlang der Schnittlinie XI-XI, und Fig. 12 die Draufsicht auf eine Leiterstruktur mit darauf fixierten elektronischen Bauteilen.

Fig. 1 zeigt die Draufsicht auf eine Leiterstruktur 1, welche vorzugsweise durch Stanzen hergestellt wird. Die Leiterstruktur 1 umfasst Leiterbahnen 2 sowie mechanische Stütz- oder Verbindungsstege 3, welche die Leiterbahnen 2 zusammenhalten.

Fig. 2 zeigt die Leiterstruktur 1 nach einem Biegevorgang, durch welchen die Leiterbahnen 2 an die entsprechenden räumlichen Erfordernisse angepasst werden können. Durch das Biegen können auch allfällige Stecker vorbereitet werden, indem beispielsweise Steckerkontakte 4 mit den Leiterbahnen 2 verbunden werden. Ebenso können durch Biegen der Leiterbahnen 2 Lötfahnen 5 od.dgl. gebildet werden. Solche Lötfahnen 5 oder Steckkontakte 4 ragen aus dem fertig hergestellten und kunststoffummantelten Produkt und dienen zum Anschluss entsprechender Komponenten oder beispielsweise der Versorgungsspannung von außen. Weiters können Positionierungselemente 6 für elektronische Bauteile od.dgl. (10 in Fig. 6 bis 8) vorgesehen werden, welche dazu dienen, dass die Bauteile in Bezug auf die Ebene der Leiterstruktur 1 symmetrisch angeordnet werden können, sodass nach dem Umspritzen oberhalb und unterhalb des Bauteils 10 gleiche Kunststoffdicken resultieren. Die in Fig. 2 dargestellte Leiterstruktur 1 wird in eine Spritzgussform eingelegt und an bestimmten Stellen, welche nicht umspritzt werden, durch Stempel od.dgl. gehalten.

Nach dem ersten Kunststoffspritzvorgang resultiert eine Leiterstruktur 1 entsprechend der Fig. 3. Dabei sind einzelne Regionen bereits mit Kunststoff 7 umspritzt. Die durch den Kunststoff 7 gebildeten Teile bieten der Leiterstruktur 1 einen besseren Halt und können allfällige Tragelemente 9 für die anzuordnenden elektronischen Bauteile 10 od.dgl. (siehe Fig. 6 bis 8) enthalten. Für die Spritzvorgänge werden vorteilhafterweise Thermoplaste verwendet. Beispielsweise kann Polybuten (PBT) eingesetzt werden, welches allenfalls mit Glasfaser z.B. zu 20 % vermischt werden kann. Dabei treten üblicherweise Werkzeugtemperaturen von 70 bis 100 °C, Massetemperaturen von 275 bis 300 °C bei einem Spritzdruck von 800 bis 1600 bar auf. Neben Polybuten können sämtliche technische Thermoplaste verwendet werden.

Fig. 4 zeigt einen Schnitt durch die Leiterstruktur 1 gemäß Fig. 3 entlang der Schnittlinie IV-IV und lässt die mit Kunststoff 7 umspritzten Regionen besser erkennen. Der Kunststoff 7 kann an der Ober- und Unterseite Noppen 8 od.dgl. aufweisen, welche die Leiterstruktur 1 für den nächsten Spritzgussvorgang in Abstand von der Spritzgussform halten. An Stelle der dargestellten Noppen 8 können verschiedenartige Ausbildungen als Abstandhalter vorgesehen sein, mit welchen ein Abstand zwischen Gussform und Leiterstruktur 1 erzielt wird.

Fig. 5 zeigt die Draufsicht auf die Leiterstruktur 1 gemäß Fig. 3 nach dem Auftrennen der mechanischen Stütz- oder Verbindungsstege 3. In diesem Schritt des Herstellungsverfahrens können die mechanischen Stütz- oder Verbindungsstege 3 entfallen, da die Leiterbahnen 2 untereinander nunmehr durch die Teile mit umspritztem Kunststoff 7 gehalten werden.

Fig. 6 zeigt ein Schnittbild durch die Leiterstruktur 1 gemäß Fig. 5 entlang der Schnittlinie VI-VI, wobei elektronische Bauteile 10 in den Tragelementen 9 angeordnet sind, welche zuvor beim ersten Umspritzen der Leiterstruktur 1 mit dem Kunststoff 7 mitgespritzt werden. Die elektronischen Bauteile 10 können in herkömmlicher Technologie oder in Form von SMD-Bauteilen (Surface mounted device) vorliegen. An Stelle von elektronischen Bauteilen 10 können auch andere elektrische, elektromechanische oder mechanische Komponenten mit Hilfe der Tragelemente 9 im Kunststoff 7 platziert werden. Um während der Spritzvorgänge den Druck und bzw. oder die Temperatur der Kunststoffmasse in der Umgebung der zu umspritzenden Leiterstruktur erfassen zu können, können entsprechende Sensoren 14 an geeigneten Stellen der Leiterstruktur 1 oder der Spritzgussform angeordnet sein. Die erfassten Daten können zur Qualitätskontrolle eingesetzt werden.

Das jeweilige Tragelement 9 für das elektronische Bauteil 10 kann entsprechend Fig. 7 mit einem Schnappverbindungsteil ausgebildet sein, in den das elektronische Bauteil 10 od.dgl. eingesteckt und von dem es selbständig gehalten wird. Dadurch wird ein sicherer Halt des Bauteils 10 od.dgl. gewährleistet. Ein Anlöten der Anschlüsse des elektronischen Bauteils 10 an die entsprechenden Leiterbahnen 2 wird dadurch ebenfalls erleichtert. Vorteilhafterweise wird das Lötverfahren mittels elektrischen Stromes, der durch die Leiterbahnen 2 in der unmittelbaren Umgebung der Anschlüsse des elektronischen Bauteils 10 geleitet wird und somit die Leiterbahnen 2 in dieser Region aufwärmt, durchgeführt. Ebenso können aber auch herkömmliche Lötverfahren angewandt werden.

Fig. 8 zeigt eine alternative Ausführungsform der Tragelemente 9 in Form eines Presssitzelementes, in welches der elektronische Bauteil 10 od.dgl. eingepresst wird. Das Tragelement kann darüber hinaus beliebige Gestalt aufweisen.

Fig. 9 zeigt eine Draufsicht auf die Leiterstruktur 1 nach dem weiteren Kunststoffspritzvorgang, wodurch ein kompaktes Gehäuse bzw. ein Teil davon gebildet wird. Wie teilweise den Schnittansichten gemäß Fig. 10 und Fig. 11 besser entnehmbar, ist gemäß dieser Ausführungsform durch den weiteren Kunststoffspritzvorgang ein Mantel 11 aus Kunststoff gebildet, welcher auch gleichzeitig ein Steckergehäuse 12 beinhaltet, in dem die Steckkontakte 4, welche mit den entsprechenden Leiterbahnen 2 verbunden sind, enthalten sind. Wenn ein Bauteil 10, z.B. ein SMD-Bauteil direkt auf die Leiterbahnen 2 aufgelegt und an diese angelötet werden, wird in der Spritzgussform über diesem Bauteil 10 eine Ausbuchtung vorgesehen, sodass die Dicke des Kunststoffes auch ober dem Bauteil 10 ausreichend groß ist. Es bildet sich somit auf dem fertigen Gehäuse eine Erhöhung 10'. Der in den Fig. 9 bis 11 dargestellte Teil wird als Komponente eines Gehäuses verwendet, weshalb im Kunststoffmantel 11 eine umlaufende Nut 13 für die Anordnung einer Dichtung (nicht dargestellt) vorgesehen ist. Der entsprechende gegenüberliegende Gehäuseteil (nicht dargestellt) kann allfällige weitere Komponenten für die elektrische Schaltungseinheit enthalten, welche beispielsweise mit den Lötfahnen 5 verbunden werden können.

Fig. 12 zeigt die Draufsicht auf eine Leiterstruktur 1, auf der bereits einige elektronische Bauteile 10 in Gestalt von SMD-Bauteilen an den Leiterbahnen 2 angelötet sind. Zu dem bereits weiter oben beschriebenen Zweck der gleichmäßigen Umhüllung der Bauteile 10 mit Kunststoff ist es zweckmäßig, die Bauteile 10 auf entsprechenden Positionierungselementen 6 zu positionieren. Diese Positionierungselemente 6 sind in Bezug auf die Ebene der Leiterstruktur 1 vertieft angeordnet (siehe Fig. 2).

Mit dem erfindungsgemäßen Verfahren kann eine elektrische Schaltungseinheit hergestellt werden, welche einen hohen Grad an Integration aufweist, indem zumindest ein Teil der elektronischen Bauteile zusammen mit den Leiterbahnen mit einem Kunststoff, insbesondere einem thermoplastischen Kunststoff, umspritzt wird. Dadurch müssen nur noch die unbedingt notwendigen Steckkontakte oder Lötfahnen zur Verbindung mit der Versorgungsspannung und andere Schnittstellen nach außen geführt werden, welche eine Fehlerquelle in Bezug auf die Dichtheit aufweisen. Somit kann eine derartige elektrische Schaltungseinheit besonders dicht und somit geschützt vor äußeren Witterungseinflüssen hergestellt werden. Insbesondere für die Massenproduktion eignet sich das Spritzgussverfahren, welches besonders rasch und kostengünstig durchgeführt werden kann.

Auf diese Weise können beispielsweise elektronische Türschlösser für Kraftfahrzeuge oder Scheibenwischerantriebe für Kraftfahrzeuge und vieles mehr hergestellt werden. Durch das erfindungsgemäße Verfahren entfällt das nachträgliche Anordnen von elektronischen Bauteilen, welche eine zusätzliche Fehlerquelle darstellt. Gegenüber herkömmlichen Verfahren, bei welchen die außerhalb der Kunststoffummantelung angeordneten elektronischen Bauteile mit einer entsprechenden Vergussmasse umhüllt wurden, weist das vorliegende Verfahren bzw. damit hergestellte Produkte einen höheren Grad an Dichtheit auf. Dadurch wird die Fehlerquote derartig hergestellter elektrischer Schaltungseinheiten deutlich reduziert.

Auf Grund der sehr raschen Spritzgussvorgänge müssen die elektronischen Bauteile, welche umspritzt werden, keine außergewöhnlich hohen Temperatur- und Druckgrenzwerte aufweisen, weshalb keine besonders hohen Anforderungen an dieselben gestellt werden müssen.

## Patentansprüche

1. Verfahren zum Herstellen einer kunststoffumspritzten Leiterstruktur einer elektrischen Schaltungseinheit, wobei die Leiterstruktur in eine Spritzgussform eingelegt und in einem ersten Kunststoffspritzvorgang teilweise umspritzt wird, **dadurch gekennzeichnet, dass** mindestens ein elektronischer Bauteil od.dgl. an der Leiterstruktur fixiert wird und dass in einem weiteren Kunststoffspritzvorgang die teilweise umspritzte Leiterstruktur samt dem zumindest einen elektronischen Bauteil od.dgl. umspritzt wird.

2. Verfahren nach Anspruch 1, **dadurch gekennzeichnet, dass** zumindest ein Bauteil od.dgl. nach dem ersten Kunststoffspritzvorgang an der Leiterstruktur fixiert wird.

3. Verfahren nach Anspruch 1 oder 2, **dadurch gekennzeichnet, dass** beim ersten Kunststoffspritzvorgang zumindest ein Bauteil-Tragelement aus dem Kunststoff mitgespritzt wird, auf dem nach dem Erstarren zumindest ein elektronischer Bauteil od.dgl. positioniert wird.

4. Verfahren nach einem der Ansprüche 1 bis 3, **dadurch gekennzeichnet, dass** ein thermoplastischer Kunststoff zum Umspritzen der Leiterstruktur verwendet wird.

5. Verfahren nach einem der Ansprüche 1 bis 4, **dadurch gekennzeichnet, dass** das Tragelement mit zumindest einem Schnappverbindungsteil während des ersten Kunststoffspritzvorganges geformt wird.

6. Verfahren nach einem der Ansprüche 1 bis 4, **dadurch gekennzeichnet, dass** das Tragelement als Presssitzelement während des ersten Kunststoffspritzvorganges geformt wird.

7. Verfahren nach einem der Ansprüche 1 bis 6, **dadurch gekennzeichnet, dass** nach dem ersten Kunststoffspritzvorgang oder nach dem Fixieren allfälliger elektronischer Bauteile od.dgl. mechanische Stütz-oder Verbindungsstege zwischen Leiterbahnen der als Leiterbahn-Stanzteil ausgebildeten Leiterstruktur aufgetrennt werden.

8. Verfahren nach einem der Ansprüche 1 bis 7, **dadurch gekennzeichnet, dass** die elektronischen Bauteile od.dgl. über lokale elektrische Erwärmung der benachbarten Leiterteile der Leiterstruktur angelötet werden.

9. Verfahren nach einem der Ansprüche 1 bis 8, **dadurch gekennzeichnet, dass** der Druck und bzw. oder die Temperatur der Kunststoffmasse in der Umgebung der zu umspritzenden Leiterstruktur während der Spritzvorgänge erfasst wird.

10. Elektrische Schaltungseinheit mit einer kunststoffumspritzten Leiterstruktur, **dadurch gekennzeichnet, dass** aus dem für die Umspritzung verwendeten Kunststoff (7) zumindest ein Tragelement (9) gebildet ist, welches zumindest einen elektronischen Bauteil (10) od.dgl. trägt, der mit einem weiteren Mantel (11) aus umspritztem Kunststoff umhüllt ist.

11. Schaltungseinheit nach Anspruch 10, **dadurch gekennzeichnet, dass** der Kunststoff (7) durch einen Thermoplast gebildet ist.

12. Schaltungseinheit nach Anspruch 10 oder 11, **dadurch gekennzeichnet, dass** das Tragelement (9) einen Schnappverbindungsteil aufweist.

13. Schaltungseinheit nach einem der Ansprüche 10 bis 12, **dadurch gekennzeichnet, dass** das Tragelement (9) als Presssitzelement ausgebildet ist.

14. Schaltungseinheit nach einem der Ansprüche 10 bis 13, **dadurch gekennzeichnet, dass** der zumindest eine elektronische Bauteil (10) od.dgl. als temperaturbeständiger Bauteil ausgeführt ist.
